# EUROPEAN PATENT SPECIFICATION

(11) **EP 2 811 516 B1**
(45) Date of publication and mention of the grant of the patent: **25.10.2017**
(21) Application number: 14163757.9
(22) Date of filing: 07.04.2014
(51) Int. Cl.: H01L 23/433, H01L 23/40, H05K 7/20, G06F 1/20

(54) **Heat dissipation device**
Wärmeableitungsvorrichtung
Dispositif de dissipation de chaleur

(30) Priority: 07.06.2013 US 201313912808
(43) Date of publication of application: 10.12.2014
(73) Proprietor: Hamilton Sundstrand Corporation, Windsor Locks, CT 06096-1010 (US)
(72) Inventor: Orsini, Luke T., Marlborough CT Connecticut 06447 (US); Desantis, Charles V., Somers CT Connecticut 06071 (US); Lin, Shun-Tien, Glastonbury CT Connecticut 06033 (US); Querns, Kerry R., Durham CT Connecticut 06422 (US); Trotman, Kenneth J., Granby CT Connecticut 06035 (US); Perley, David, Manchester CT Connecticut 06042 (US)
(74) Representative: Leckey, David Herbert

(56) References cited:
- EP-A2- 1 689 220
- JP-A- H10 173 111
- JP-A- 2003 163 477
- JP-A- 2007 048 914
- JP-A- 2013 012 631
- US-A- 4 748 495
- US-A1- 2009 009 971

## Description

### BACKGROUND

In an aerospace environment, mitigation strategies may be needed to ensure reliable and safe operation of an electronic device (e.g., a processor). If the device gets too hot (e.g., reaches a temperature that exceeds a threshold), the operation of the device may be degraded or even cease altogether.

It can be difficult to implement mitigation strategies in an aerospace environment. For example, a lack of space and airflow might not allow a fan to be used to cool a device. Further complicating matters is the fact that a first instance of the device may vary from a second instance of the device due to an allowable tolerance in materials or fabrication processes used to manufacture the device.

An apparatus having the features of the preamble of claim 1 is disclosed in JP H10 173111 A. Other apparatuses for removing heat from electronic devices are disclosed in JP 2013 012631 A, JP 2003 163477 A, JP 2007 048914 A, US 2009/009971 A1 and EP 1689220 A2.

### BRIEF SUMMARY

From a first aspect, the invention provides an apparatus as set forth in claim 1. The invention also provides a method as set forth in claim 8.

Additional embodiments are described below.

### BRIEF DESCRIPTION OF THE DRAWINGS

The present disclosure is illustrated by way of example and not limited in the accompanying figures in which like reference numerals indicate similar elements.
FIG. 1 is a block diagram illustrating a thermal strap and block in accordance with one or more embodiments;
FIG. 2 illustrates a thermal strap coupled to retention hardware in accordance with one or more embodiments;
FIG. 3 illustrates an assembly in accordance with one or more embodiments;
FIG. 4 illustrates an assembly in accordance with one or more embodiments; and
FIG. 5 illustrates a flow chart of an exemplary method in accordance with one or more embodiments.

### DETAILED DESCRIPTION

It is noted that various connections are set forth between elements in the following description and in the drawings (the contents of which are included in this disclosure by way of reference). It is noted that these connections in general and, unless specified otherwise, may be direct or indirect and that this specification is not intended to be limiting in this respect. In this respect, a coupling between entities may refer to either a direct or an indirect connection.

Exemplary embodiments of apparatuses, systems, and methods are described for mitigating the impact of environmental conditions on the availability and functionality of a device, such as a processor. In some embodiments, the device may be associated with an engine or airframe of an aircraft. In some embodiments, an assembly may include adjustment or retention hardware and a block that are configured to mitigate or avoid applications of stress to the device. The assembly may include a spring to control a load that may be placed on the device. The assembly may include a strap that may conduct heat away from the device.

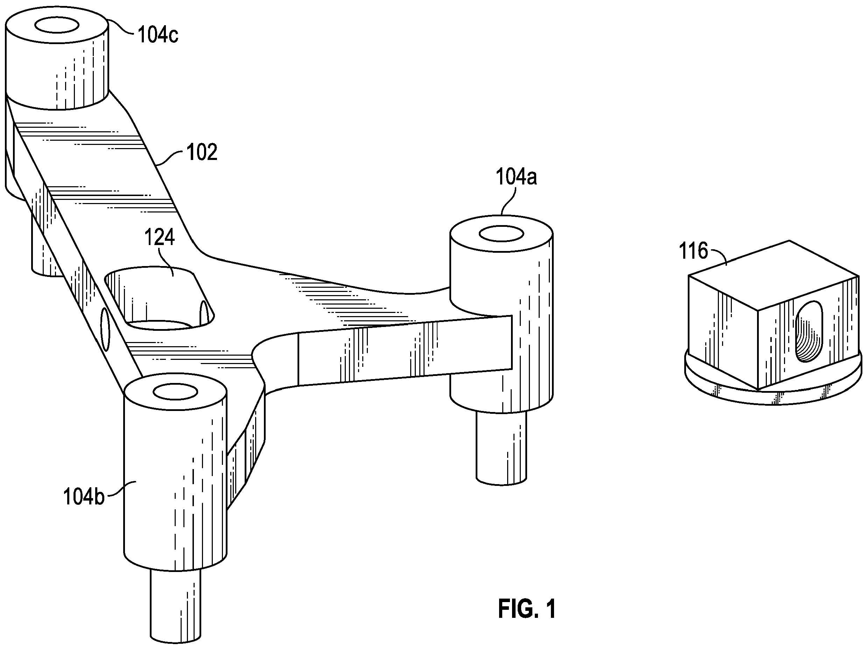

Referring to FIG. 1, exemplary components in accordance with one or more embodiments are shown. More specifically, a thermal strap 102 is shown. The strap 102 may be made of one or more materials or elements, such as aluminum. The strap 102 may be lightweight and may be used to conduct heat way from a device (e.g., a processor) that the strap 102 is applied to. The strap 102 may include one or more posts, such as posts 104a-104c. The posts 104a-104c may be coupled to a heat sink (not shown) or may be coupled to a housing (not shown). In this manner, heat may be transferred from the device to the strap 102, from the strap 102 to the posts 104a-104c, from the posts 104a-104c to the heat sink or to the housing. The transfer of heat may be used to keep the temperature of the device below a threshold.

In some embodiments, the device (e.g., the processor) may be subject to one or more tolerances, such that a configurable or flexible assembly may be needed. In other words, simply applying a fixed-configuration strap 102 to the device could result in a substantial risk of damage to the device. In this respect, a thermal block 116 may be used. The block 116 may float within a cutout 124 of the strap 102 such that the device will not be crushed or damaged. The block 116 may float while the strap 102, which may include one or more posts, is fastened or coupled to the heat sink or to the housing.. The block 116 is also used to provide thermal conduction between, e.g., the device and the strap 102.

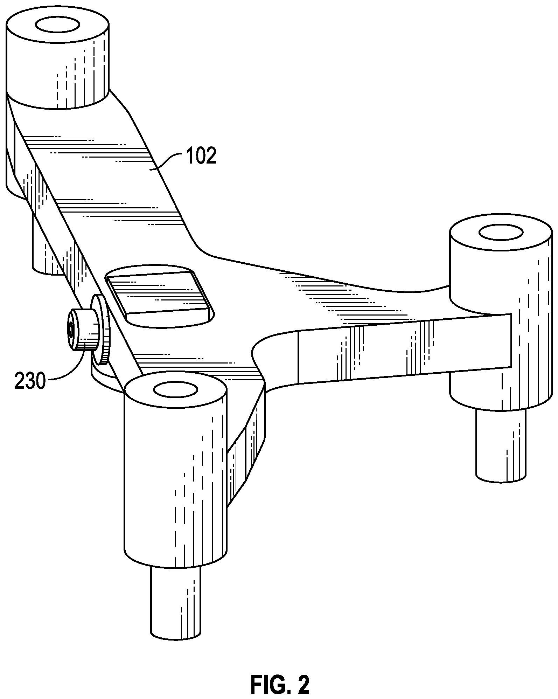

Referring now to FIG. 2, the strap 102 is shown as being coupled to, or including, adjustment or retention hardware 230. The retention hardware 230 may include a washer and a screw. The retention hardware 230 may be configured to retain the block 116 within the strap 102 in order to mitigate against the impact of variable environmental conditions, such as load or vibration.

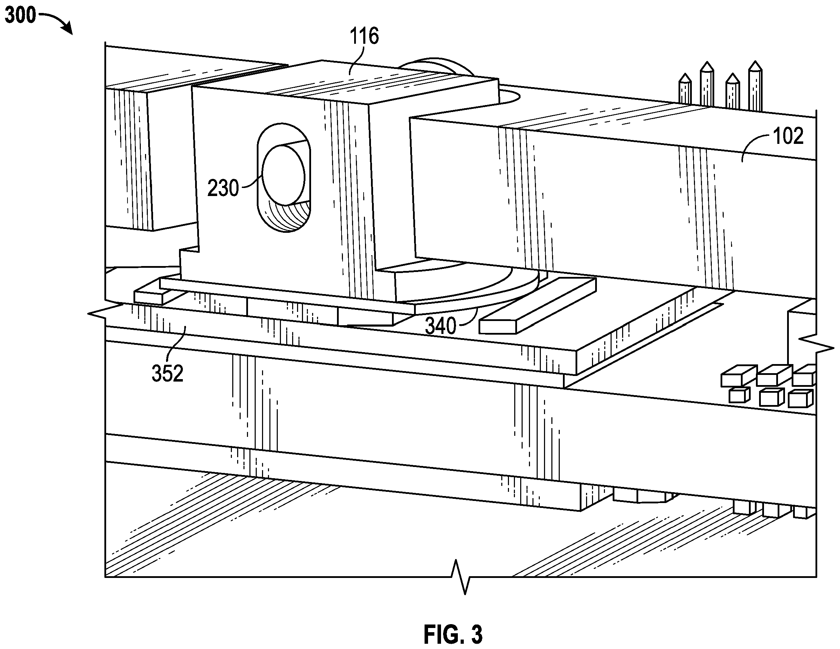

Referring now to FIG. 3, an assembly 300 is shown. The assembly 300 may include the strap 102, the block 116 and the retention hardware 230 of FIGS. 1-2. The assembly 300 may include a thermal pad 340. The thermal pad 340 may be used to enhance the conductivity (e.g., thermal conductivity) between a device 352 and the block 116/strap 102. The device 352 may include one or more electronic devices, such as a microprocessor.

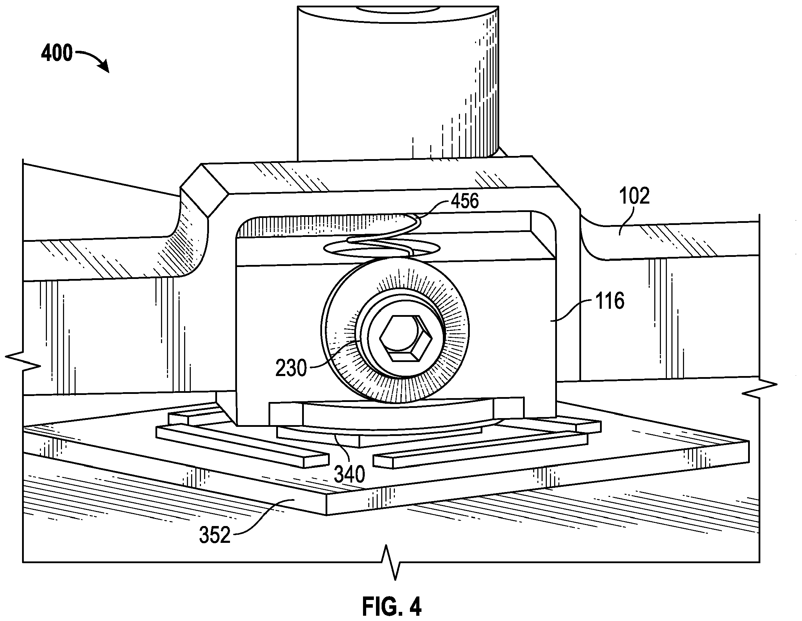

When a technician or operator is putting together or constructing the assembly 300, it is possible that the operator might be inclined to press down on, or apply pressure to, the top of the block 116. This application of pressure, if not controlled, may be sufficient to damage or crack (the die of) the device 352. FIG. 4 illustrates an exemplary assembly 400 that may be used to control the applied pressure. The assembly 400 is shown as including the strap 102, the block 116, the retention hardware 230, and the pad 340. The assembly 456 may include a spring 456 coupled to the block 116. The spring 456 may be used to control the amount of load on the device 352. For example, the spring 456 may be used to ensure that there is adequate contact between the device 352 and the block 116 during, e.g., construction of the assembly 400, such that an operator/technician might not have to press down on the block 116. More generally, the spring 456 may be used to ensure that there is controlled load between the device 352 and the block 116.

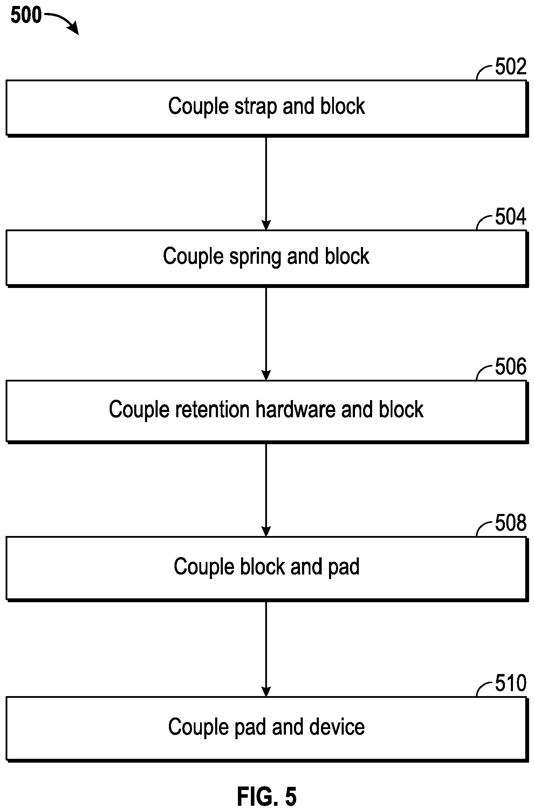

Referring now to FIG. 5, a flow chart of an exemplary method 500 is shown. The method 500 may be used to construct an assembly, such as the assemblies 300 and 400.

In operation 502, a strap (e.g., strap 102) and a block (e.g., block 116) may be coupled to one another.

In operation 504, a spring (e.g., spring 456) and the block may be coupled to one another.

In operation 506, retention hardware (e.g., retention hardware 230) and the block 506 may be coupled to one another.

In operation 508, the block and a pad (e.g., pad 340) may be coupled to one another.

In operation 510, the pad and a device (e.g., device 352) may be coupled to one another.

The method 500 is illustrative. In some embodiments, one or more of the operations may be optional. In some embodiments, additional operations not shown may be included. In some embodiments, the operations may execute in an order or sequence that is different from what is shown in FIG. 5.

As described herein, in some embodiments various functions or acts may take place at a given location and/or in connection with the operation of one or more apparatuses, systems, or devices. For example, in some embodiments, a portion of a given function or act may be performed at a first device or location, and the remainder of the function or act may be performed at one or more additional devices or locations.

Aspects of the disclosure have been described in terms of illustrative embodiments thereof. Numerous other embodiments, modifications and variations within the scope of the appended claims will occur to persons of ordinary skill in the art from a review of this disclosure. For example, one of ordinary skill in the art will appreciate that the steps described in conjunction with the illustrative figures may be performed in other than the recited order, and that one or more steps illustrated may be optional.

## Claims

1. An apparatus comprising:
a thermal block (116) coupled to an electronic device (352);
a thermal strap (102) coupled to the thermal block (116); and
retention hardware (230) coupled to the thermal strap (102); **characterised in that**:
the retention hardware (230) extends through the thermal block (116) to retain the thermal block (116) within the thermal strap (102) when the apparatus is exposed to at least one variable environmental condition.

2. The apparatus of claim 1, wherein the retention hardware (230) comprises a washer and a screw.

3. The apparatus of claim 1 or 2, further comprising:
a thermal pad (340) coupled to the thermal block (116) and the electronic device (352).

4. The apparatus of any preceding claim, wherein the at least one variable environmental condition comprises at least one of temperature and vibration.

5. The apparatus of any preceding claim, further comprising:
a spring (456) coupled to the thermal block (116) and configured to control a load on the electronic device (352).

6. The apparatus of any preceding claim, wherein the apparatus is included on a vehicle.

7. The apparatus of any preceding claim, wherein the thermal strap (102) comprises a plurality of posts (104), and wherein the posts (104) are coupled to at least one of a heat sink and a housing.

8. A method of regulating heat of an apparatus comprising:
providing a thermal strap (102) and a thermal block (116);
coupling to the strap (102) retention hardware (230) which extends through the thermal block (116) to retain the thermal block (116) within the thermal strap (102) when the apparatus is exposed to at least one variable environmental condition; and
coupling the thermal block (116) to an electronic device (352).

9. The method of claim 8, wherein the electronic device (352) has at least one associated tolerance from a first instance of the electronic device (352) to a second instance of the electronic device (352).

10. The method of claim 9 or 10, further comprising:
coupling a thermal pad (340) configured to enhance thermal conductivity between the thermal block (116) and the electronic device (352).

11. The method of claim 9, 10 or 11, wherein the at least one variable environmental condition comprises at least one of temperature and vibration.

12. The method of any of claims 8 to 11, further comprising:
coupling a spring (456) to the thermal block (116).

13. The method of claim 12, wherein the spring (456) is configured to maintain contact and a controlled load between the electronic device (352) and the thermal block (116).

14. The method of any of claims 8 to 13, wherein the thermal strap (102) comprises a plurality of posts (104), the method further comprising:
coupling the posts (104) and a heat sink;
coupling the heat sink and a housing; and
coupling the posts (104) and the housing.

## Patentansprüche

1. Vorrichtung, umfassend:
einen Wärmeblock (116), der an eine elektronische Vorrichtung (352) gekoppelt ist;
ein Wärmeband (102), das an den Wärmeblock (116) gekoppelt ist; und
eine Halterungshardware (230), die an das Wärmeband (102) gekoppelt ist; **dadurch gekennzeichnet, dass**:
sich die Halterungshardware (230) durch den Wärmeblock (116) erstreckt, um den Wärmeblock (116) innerhalb des Wärmebands (102) zu halten, wenn die Vorrichtung mindestens einer variablen Umweltbedingung ausgesetzt ist.

2. Vorrichtung nach Anspruch 1, wobei die Halterungshardware (230) eine Unterlegscheibe und eine Schraube umfasst.

3. Vorrichtung nach Anspruch 1 oder 2, ferner umfassend:
ein Wärmepolster (340), das an den Wärmeblock (116) und die elektronische Vorrichtung (352) gekoppelt ist.

4. Vorrichtung nach einem der vorhergehenden Ansprüche, wobei die mindestens eine variable Umweltbedingung mindestens eines von Temperatur und Vibration umfasst.

5. Vorrichtung nach einem der vorhergehenden Ansprüche, ferner umfassend:
eine Feder (456), die an den Wärmeblock (116) gekoppelt ist und konfiguriert ist, eine Last an der elektronischen Vorrichtung (352) zu steuern.

6. Vorrichtung nach einem der vorhergehenden Ansprüche, wobei die Vorrichtung in einem Fahrzeug enthalten ist.

7. Vorrichtung nach einem der vorhergehenden Ansprüche, wobei das Wärmeband (102) eine Vielzahl von Pfosten (104) umfasst, und wobei die Pfosten (104) an mindestens eines von einer Wärmesenke und einem Gehäuse gekoppelt sind.

8. Verfahren zum Regeln der Wärme einer Vorrichtung, umfassend:
Bereitstellen eines Wärmebands (102) und eines Wärmeblocks (116);
Koppeln einer Halterungshardware (230), die sich durch den Wärmeblock (116) erstreckt, an das Band (102), um den Wärmeblock (116) innerhalb des Wärmebands (102) zu halten, wenn die Vorrichtung mindestens einer variablen Umweltbedingung ausgesetzt ist; und
Koppeln des Wärmeblocks (116) an die elektronische Vorrichtung (352).

9. Verfahren nach Anspruch 8, wobei die elektronische Vorrichtung (352) mindestens eine zugeordnete Toleranz von einer ersten Instanz der elektronischen Vorrichtung (352) zu einer zweiten Instanz der elektronischen Vorrichtung (352) aufweist.

10. Verfahren nach Anspruch 9 oder 10, ferner umfassend:
Koppeln eines Wärmepolsters (340), das konfiguriert ist, die Wärmeleitfähigkeit zwischen dem Wärmeblock (116) und der elektronischen Vorrichtung (352) zu verbessern.

11. Verfahren nach Anspruch 9, 10 oder 11, wobei die mindestens eine variable Umweltbedingung mindestens eines von Temperatur und Vibration umfasst.

12. Verfahren nach einem der Ansprüche 8 bis 11, ferner umfassend:
Koppeln einer Feder (456) an den Wärmeblock (116).

13. Verfahren nach Anspruch 12, wobei die Feder (456) konfiguriert ist, Kontakt und eine gesteuerte Last zwischen der elektronischen Vorrichtung (352) und dem Wärmeblock (116) zu halten.

14. Verfahren nach einem der Ansprüche 8 bis 13, wobei das Wärmeband (102) eine Vielzahl von Pfosten (104) umfasst, wobei das Verfahren ferner Folgendes umfasst:
Koppeln der Pfosten (104) und einer Wärmesenke;
Koppeln der Wärmesenke und eines Gehäuses; und
Koppeln der Pfosten (104) und des Gehäuses.

## Revendications

1. Appareil comprenant :
un bloc thermique (116) couplé à un dispositif électronique (352) ;
un étrier thermique (102) couplé au bloc thermique (116) ; et
un équipement de retenue (230) couplé à l'étrier thermique (102) ; caractérisé en ce qui :
l'équipement de retenue (230) s'étend à travers le bloc thermique (116) pour retenir le bloc thermique (116) à l'intérieur de l'étrier thermique (102) lorsque l'appareil est exposé à au moins une condition ambiante variable.

2. Appareil selon la revendication 1, dans lequel l'équipement de retenue (230) comprend une rondelle et une vis.

3. Appareil selon la revendication 1 ou 2, comprenant en outre :
une plaquette thermique (340) couplée au bloc thermique (116) et au dispositif électronique (352).

4. Appareil selon l'une quelconque des revendications précédentes, dans lequel l'au moins une condition ambiante variable comprend au moins l'une parmi une température et une vibration.

5. Appareil selon l'une quelconque des revendications précédentes, comprenant en outre :
un ressort (456) couplé au bloc thermique (116) et configuré pour commander une charge sur le dispositif électronique (352).

6. Appareil selon l'une quelconque des revendications précédentes, dans lequel l'appareil est compris dans un véhicule.

7. Appareil selon l'une quelconque des revendications précédentes, dans lequel l'étrier thermique (102) comprend une pluralité de montants (104), et dans lequel les montants (104) sont couplés à au moins l'un parmi un dissipateur de chaleur et un boîtier.

8. Procédé de régulation de la chaleur d'un appareil comprenant :
la fourniture d'un étrier thermique (102) et d'un bloc thermique (116) ;
le couplage à l'étrier (102) d'un équipement de retenue (230) qui s'étend à travers le bloc thermique (116) pour retenir le bloc thermique (116) à l'intérieur de l'étrier thermique (102) lorsque l'appareil est exposé à au moins une condition ambiante variable ; et
le couplage du bloc thermique (116) à un dispositif électronique (352).

9. Procédé selon la revendication 8, dans lequel le dispositif électronique (352) présente au moins une tolérance associée d'une première instance du dispositif électronique (352) à une seconde instance du dispositif électronique (352).

10. Procédé selon la revendication 9 ou 10, comprenant en outre :
le couplage d'une plaquette thermique (340) configurée pour accroître une conductivité thermique entre le bloc thermique (116) et le dispositif électronique (352).

11. Procédé selon la revendication 9, 10 ou 11, dans lequel l'au moins une condition ambiante variable comprend au moins l'une parmi une température et une vibration.

12. Procédé selon l'une quelconque des revendications 8 à 11, comprenant en outre :
le couplage d'un ressort (456) au bloc thermique (116).

13. Procédé selon la revendication 12, dans lequel le ressort (456) est configuré pour maintenir un contact et une charge contrôlée entre le dispositif électronique (352) et le bloc thermique (116).

14. Procédé selon l'une quelconque des revendications 8 à 13, dans lequel l'étrier thermique (102) comprend une pluralité de montants (104), le procédé comprenant en outre :
le couplage des montants (104) et d'un dissipateur de chaleur ;
le couplage du dissipateur de chaleur et d'un boîtier ; et
le couplage des montants (104) et du boîtier.
